# EUROPEAN PATENT APPLICATION

(11) **EP 2 327 618 A1**
(43) Date of publication of application: **01.06.2011**
(21) Application number: 09816007.0
(22) Date of filing: 17.08.2009
(51) Int. Cl.: B63B 21/14, B63B 9/00, G06F 17/50

(54) **BELL MOUTH DESIGN METHOD**

(30) Priority: 24.09.2008 JP 2008245046
(71) Applicant: IHI Marine United Inc., Tokyo 108-0022 (JP)
(72) Inventor: SUEOKA, Masaki, Tokyo 108-0022 (JP); WATANABE, Kentaro, Tokyo 108-0022 (JP)
(74) Representative: Banzer, Hans-Jörg
(86) International application number: PCT/JP2009/064394
(87) International publication number: WO 2010/035590

(57) **Abstract**

Provided is a bell mouth design method whereby a bell mouth shape suitable for a ship type can be designed easily without depending on specific craftsmen. The bell mouth design method of the present invention has an initial shape setting step (Step 1) for setting the initial shape of the bell mouth 4; a three-dimensional model creation step (Step 2) for creating the three-dimensional model of the bell mouth 4 and other parts on a computer; a preliminary shape modification step (Step 3) for modifying the outer peripheral shape of the three-dimensional model of the bell mouth 4 so as to be rotatable when the anchor 3 contacts the initial shape of the bell mouth 4; a mechanical analysis step (Step 4) for performing a mechanical analysis of the condition of the anchor 3 being housed using the three-dimensional model of the bell mouth 4 and other parts on a computer; a determination step (Step 5) for checking whether the results of the mechanical analysis satisfy predetermined conditions; and a shape modification step (Step 6) for modifying three-dimensional model of the bell mouth 4 on the computer on the basis of results of the mechanical analysis

## Description

### Technical Field

The present invention relates to a method for designing a bell mouth constituting the housing location of a ship anchor, and particularly relates to a bell mouth design method characterized in designing the shape of a bell mouth using a computer.

### Background Art

In general, a ship has a winch disposed on a deck, a hawse pipe arranged from the deck through a shell plating, a chain connected to the winch through the hawse pipe, and an anchor connected to the distal end of the chain. The anchor is driven into the seabed to keep the ship in place when the ship is to be moored at sea, and the anchor is stored in the side shell plating when the ship is navigating. A bell mouth is arranged on the outer end of the hawse pipe to wind up the chain smoothly and secure the anchor stably. The bell mouth is substantially donut-shaped as described in Patent Document 1, for example. The shape of the bell mouth varies depending on the ship type and is therefore sometimes designed using a bell mouth model test device such as that described in Patent Document 2, for example.

Specifically, the shape of a bell mouth is often designed through the following steps:
(1) Determining the initial shape based on the diagrams of the anchor, chain, and hawse pipe, with the size and shape roughly set depending on the type of ship;
(2) Molding a reduced scale model while manually cutting away material of the initial shape and adding material on the initial shape;
(3) Carrying out a model test (lift anchor test, and other tests) using the reduced-scale model;
(4) Confirming the behavior of the chain during anchor lift and the condition of the anchor being housed to examine whether the bell mouth satisfies predetermined functions;
(5) Repeating the molding and model testing of the reduced-scale model depending on the study results;
(6) Making a full-scale model from the reduced-scale model to produce drawings and two-dimensional CAD data after a shape satisfying the predetermined functions has been obtained; and
(7) Fabricating a full-scale resin wood model to form a bell mouth cast after the shape of the bell mouth has been designed using the steps (1) to (6) described above.

Patent Document 1: Japanese Laid-open Utility Model Application No. 6-23894
Patent Document 2: Japanese Utility Model Publication No. 3-31674

### SUMMARY OF INVENTION

### Technical Problem

With the conventional bell mouth design method described above, the initial shape is determined based on the experience and intuition of the craftsman. The manner in which the reduced-scale model is molded and the manner in which the reduced-scale model is molded based on the model test also depend on the knowhow of the craftsman. There is a problem in the handing down of the skill due to the decrease in the number of the craftsmen with such skill.

The present invention was devised in view of the problems described above. An object of the present invention is to provide a bell mouth design method whereby a bell mouth shape suitable for a ship type can be designed easily without depending on specific craftsmen.

### Solution to Problem

According to the present invention, there is provided a method for designing a bell mouth in a ship having a hawse pipe formed in a shell plating of the ship, an anchor arranged so as to be raised and lowered by a chain passing through the hawse pipe, and a bell mouth arranged on the outer end of the hawse pipe, the method for designing a bell mouth comprising an initial shape setting step for setting an initial shape of the bell mouth depending on the type of ship, and the shape of the hawse pipe and the anchor; a three-dimensional model creation step for creating a three-dimensional model of the bell mouth, the hawse pipe, and the anchor on a computer; a mechanical analysis step for performing a mechanical analysis of the condition of the anchor being housed using the three-dimensional model of the bell mouth, the hawse pipe, and the anchor on the computer; a determination step for checking whether the results of the mechanical analysis satisfy predetermined conditions; and a shape modification step for modifying the three-dimensional model of the bell mouth on the computer on the basis of the results of the mechanical analysis, wherein the shape of the bell mouth is decided while repeating the mechanical analysis step and the shape modification step.

A preliminary shape modification step for modifying the outer peripheral shape of the three-dimensional model of the bell mouth so as to be rotatable when the anchor contacts the initial shape of the bell mouth may be inserted after the three-dimensional creation step.

In the initial shape setting step, an internal diameter of the initial shape of the bell mouth is set based on a diameter of the hawse pipe, and an external diameter and a height of the initial shape of the bell mouth is set based on a size of and the shape of the anchor, for example. In the initial shape setting step, a profile of the initial shape of the bell mouth may be set using a database in which bell mouth shapes of existing ships have been converted into CAD data and stored with their associated ship-type information,.

In the mechanical analysis step, a mechanical analysis is performed for the condition of the anchor in a stored or anchored state in addition to the condition of the anchor being housed.

In the shape modification step or the preliminary shape modification step, the three-dimensional model of the bell mouth is preferably modified on the computer using a haptic device. The predetermined conditions in the determination step are that the direction of the anchor in a stored state is constant; that the anchor does not contact the shell plating when the anchor is being housed; and that the anchor contacts the bell mouth at three points when the anchor is in a stored state, for example. In the shape modification step, the height of the bell mouth may be modified to adjust the contact points between the anchor and the bell mouth, and the difference between a lowest point and a highest point of the height of the bell mouth may be modified to adjust the swing width of the anchor and the distance between the anchor and the shell plating.

### Advantageous Effects of Invention

According to the bell mouth design method of the present invention described above, a bell mouth shape suitable for a ship type can be designed easily without depending on specific craftsmen by creating a three-dimensional model on a computer and performing a mechanical analysis to modify the shape. Since a reduced-scale model or a wood model is no longer necessary, design time can shortened and design costs can be reduced. Three-dimensional data of bell mouths can furthermore be accumulated and used in the design of future bell mouths, and a bell mouth design can be implemented more rapidly and at lower cost by using the bell mouth design method of the present invention.

### DESCRIPTION OF EMBODIMENTS

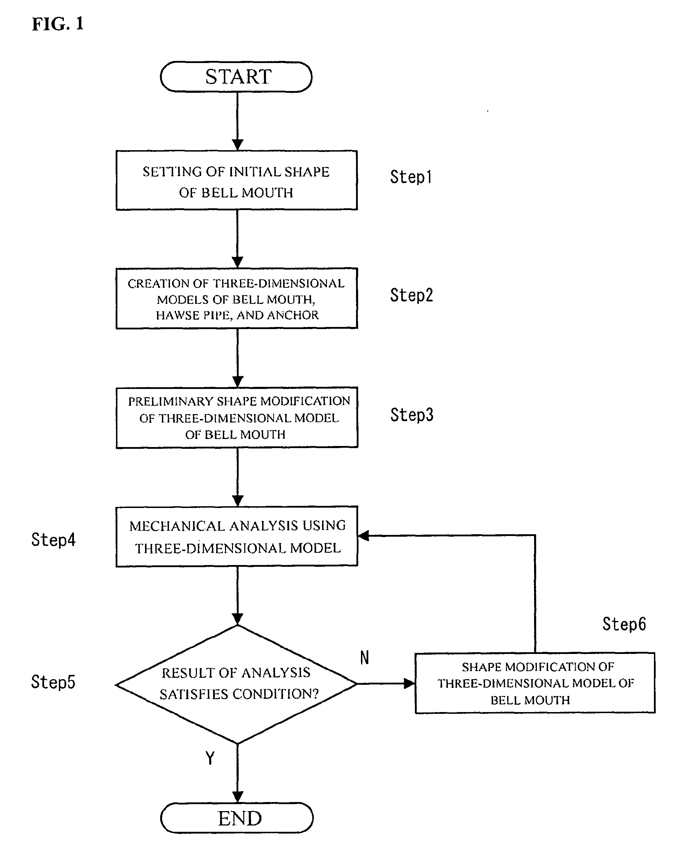

Embodiments of the present invention are described below with reference to FIGS. 1 to 9. FIG. 1 is a processing flowchart showing the bell mouth design method according to the present invention.

As shown in FIG. 1, the bell mouth design method of the present invention is a method for designing a bell mouth 4 in a ship having a hawse pipe 2 formed in a shell plating 1 of a ship, an anchor 3 arranged so as to be raised and lowered by a chain passing through the hawse pipe 2, and a bell mouth 4 arranged on the outer end of the hawse pipe 2, the method for designing a bell mouth comprising an initial shape setting step (Step 1) for setting an initial shape of the bell mouth 4 depending on the type of ship, and the shape of the hawse pipe 2 and the anchor 3; a three-dimensional model creation step (Step 2) for creating a three-dimensional model of the bell mouth 4, the hawse pipe 2, and the anchor 3 on a computer; a preliminary shape modification step (Step 3) for modifying the outer peripheral shape of the three-dimensional model of the bell mouth 4 so as to be rotatable when the anchor 3 contacts the initial shape of the bell mouth 4; a mechanical analysis step (Step 4) for performing a mechanical analysis of the condition of the anchor 3 being housed using the three-dimensional model of the bell mouth 4, the hawse pipe 2, and the anchor 3 on the computer; a determination step (Step 5) for checking whether the results of the mechanical analysis satisfy predetermined conditions; and a shape modification step (Step 6) for modifying the three-dimensional model of the bell mouth 4 on the computer on the basis of the results of the mechanical analysis, wherein the shape of the bell mouth 4 is decided while repeating the mechanical analysis step (Step 4) and the shape modification step (Step 6).

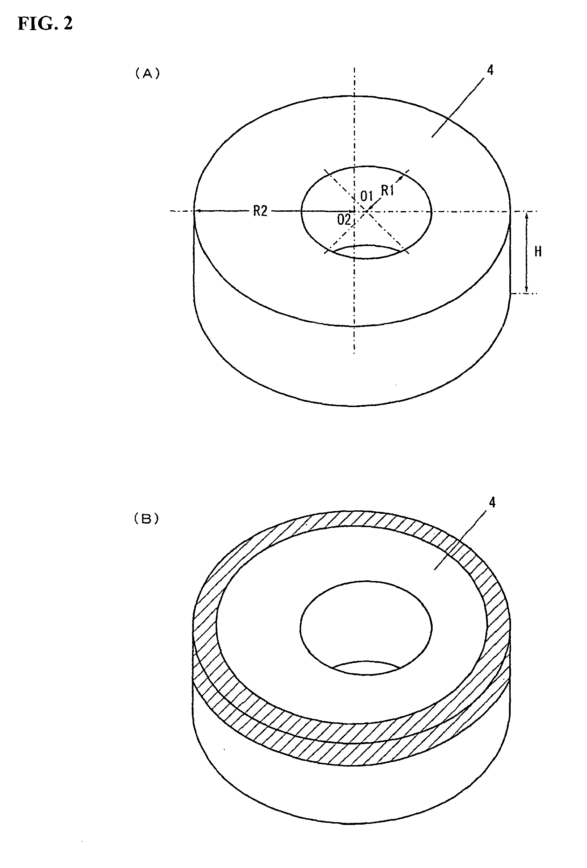

In the initial shape setting step (Step 1), the initial shape that will become three-dimensional pattern of the bell mouth 4 is set. The initial shape is selected depending on the type of ship and the shape of the hawse pipe 2 and the anchor 3. The type of ship includes tankers and passenger ships, as well as types based on deadweight, total length, and other size factors. The shape of the hawse pipe 2 and the anchor 3 are set in advance from the shape of the hull. The bell mouth 4 is arranged on the outer end of the hawse pipe 2, and contacts anchor 3 and the chain connected to the anchor 3. The bell mouth 4 must contact these components smoothly, and must accommodate the anchor 3 in a stable state. FIG. 2 is a diagram showing the initial shape of a bell mouth, wherein (A) is the external appearance of the initial shape and (B) is the external appearance of a bell mouth which has undergone preliminary shape modification.

In FIG. 2, R1 is the inside diameter (radius) of the bell mouth 4, R2 is the outside diameter (radius), and H is the height. First, the inside diameter R1 of the bell mouth 4 is set from the diameter (radius or diameter) of the hawse pipe 2. Specifically, the inside diameter R1 of the bell mouth 4 is set to be the same size as the radius of the hawse pipe 2 in order to smoothly connect the hollow portion of the hawse pipe 2 and the hollow portion of the bell mouth 4. The outside diameter R2 and the height H of the bell mouth 4 are set based on the size and shape of the anchor 3. For example, assuming a state in which the anchor 3 is stored so as not to contact the shell plating 1, the outside diameter R2 and height H of the bell mouth 4 are set based on the size of the space enclosed by the hawse pipe 2, anchor 3, and shell plating 1. Therefore, there are settings in which the center O1 of the inside diameter R1 and the center 02 of the outside diameter R2 do not match each other, as shown in FIG. 2(A). Naturally, the center O1 and the center 02 may also be set to match each other. The initial shape of the bell mouth 4 is set so as to form a hollow cylinder, as shown in FIG. 2(A), for example.

In the three-dimensional model creation step (Step 2), a three-dimensional model of the bell mouth 4, the hawse pipe 2, and the anchor 3 are created. The behavior of the anchor 3 and the contact conditions and the like between the bell mouth 4 and the anchor 3 can be expressed on a computer by creating a three-dimensional model of these components. The three-dimensional model may be created with commercially available computer software.

In the preliminary shape modification step (Step 3), the initial shape of the bell mouth 4 formed in a hollow cylindrical shape is roughly modified using the three-dimensional model created in the three-dimensional model creation step (Step 2). For example, the outer peripheral shape of the three-dimensional model of the bell mouth 4 is modified so as to be rotatable when the anchor 3 contacts the initial shape of the bell mouth 4, as shown in FIG. 2(B). At this point, the outer peripheral shape of the three-dimensional model is modified so that the angled portion of the bell mouth 4 indicated by the shaded part in FIG. 2(B) is rounded. The shape modification of the three-dimensional model may be modification by data input from a keyboard or by mouse operation on a computer, but it is also possible to use a haptic device. A haptic device is a tool for substituting and artificially expressing as data the tactile, force, or other haptic information obtained when a human contacts an object. Haptic devices include pens, gloves, six-degrees-of-freedom manipulators, and other various devices, but the shape of the three-dimensional model can be most easily modified using a six-degrees-of-freedom manipulator-type haptic device.

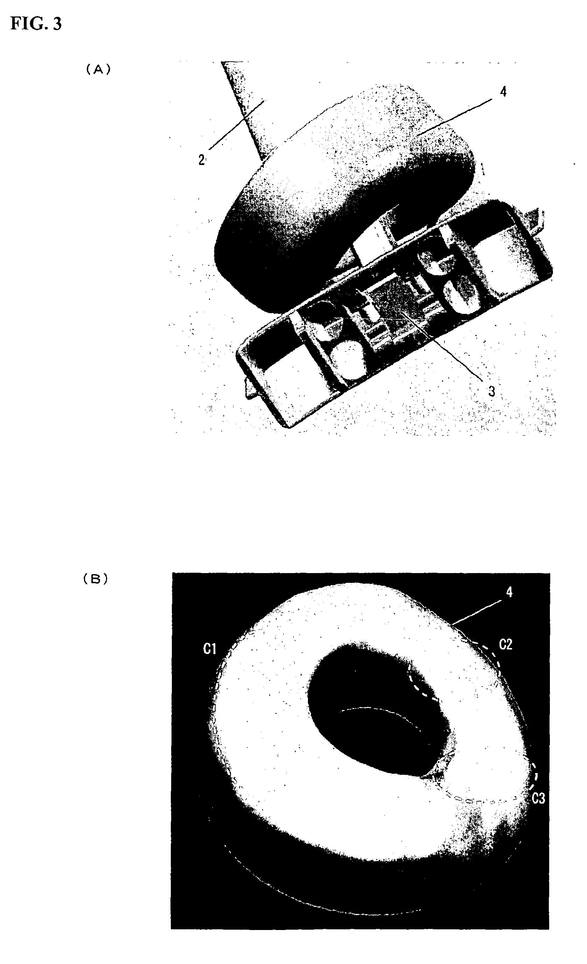

It is also possible to modify more specifically the outer peripheral shape of the three-dimensional model of the bell mouth 4 using the three-dimensional model of the anchor 3 and the bell mouth 4. FIG. 3 is a view showing the preliminary shape modification step using a three-dimensional model, wherein (A) shows the anchor in a stored state and (B) shows the bell mouth having undergone preliminary shape modification. As shown in FIG. 3(A), the bell mouth 4 is connected to the outer end of the hawse pipe 2. The anchor 3 is pulled by a chain passing through the hawse pipe 2 thereby being stored in contact with the bell mouth 4. The anchor 3 is often inclined to one side of the surface of the bell mouth 4 and stored as shown in FIG. 3(A). In FIG. 3(B), C1 to C3 show the contact portions of the anchor 3 and bell mouth 4, and it is easily understood that the contact portions C2, C3 have more height removed than the contact portion C1. The three-dimensional model of the bell mouth 4 can be modified in the steps up to this point without performing a mechanical analysis. As shall be apparent, the preliminary shape modification step where three-dimensional model is used can be omitted to proceed to the next step, which is the mechanical analysis step (Step 4), using the initial shape of the bell mouth 4 or the three-dimensional model after the preliminary shape modification step shown in FIG. 2(A).

In the mechanical analysis step (Step 4), the behavior of the anchor 3 and the bell mouth 4 is analyzed using the created three-dimensional model. The mechanical analysis can be carried out using commercially available software, such as "ADAMS" produced by MSC Software, and "NX Design" produced by Siemens PLM Software. Such mechanical analysis software enables, for example, initial state analysis (analysis of whether there are inconsistencies in the model of the initial state); static equilibrium analysis (analysis in a state in which the internal and external forces of the mechanical model at a certain time are in equilibrium); quasi-static equilibrium analysis (static equilibrium analysis at each moment in time when a certain portion of the structure has been varied in time intervals); linear analysis/characteristic value analysis (analysis for specifying and linearizing at a certain point in time the mechanical model expressed by a non-linear formula); kinematic analysis (analysis of the mechanical motion of the mechanical model when the mechanical model has no degree of freedom); and dynamic analysis (analysis of the mechanical motion of the mechanical model when the mechanical model has a degree of freedom). The analysis results are displayed in graphs, data plots, reports, animation, and other forms.

In the mechanical analysis step (Step 4), the condition of the anchor 3 in a anchored state, the condition of the anchor 3 being housed while the chain is being wound up, and the condition of the anchor 3 in a stored state after the chain has been wound up are subjected to mechanical analysis. The mechanical analysis is preferably carried out under various conditions while joint speed during the mechanical analysis is varied, the orientation of the flukes of the anchor 3 is reversed front and back, and the conditions of the pull on bow and stern are changed (e.g., varying the direction of gravity and tilting the entire model).

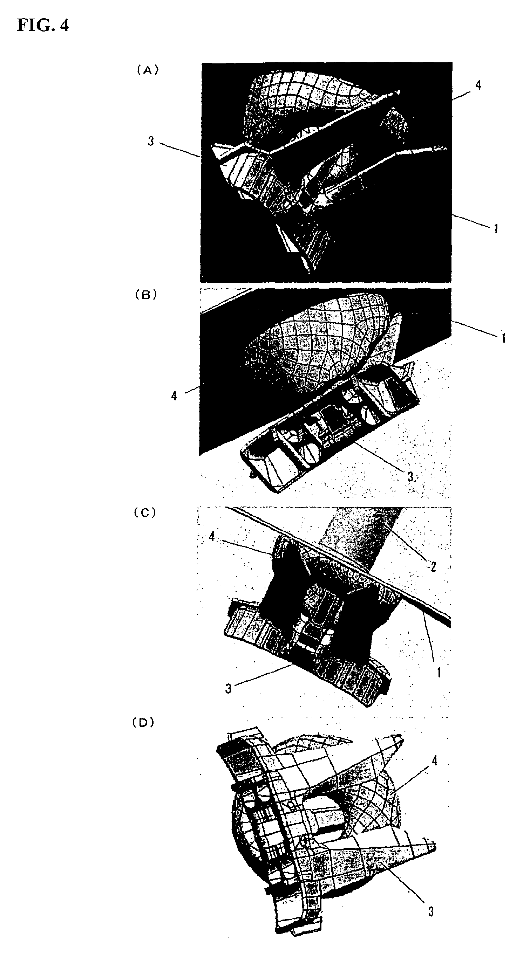

FIG. 4 is a view showing the state of mechanical analysis, wherein (A) is a bird's-eye view, (B) is a side view from the rear of the anchor, (C) is a side view from the front of the anchor, and (D) is a plan view. The mechanical analysis is carried out by dividing the anchor 3, the bell mouth 4, and the like into meshed elements using the finite element method or the like, as shown in FIG. 4.

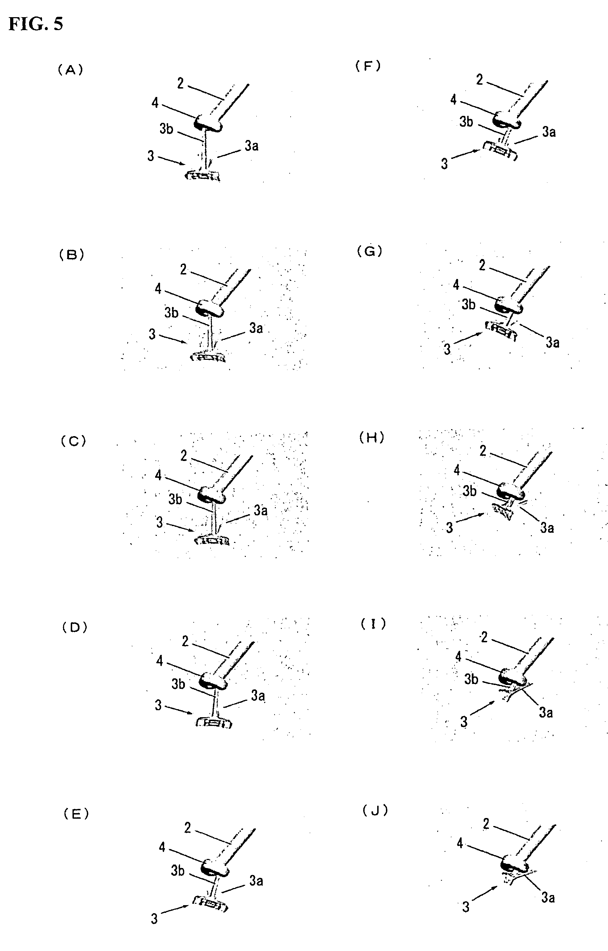

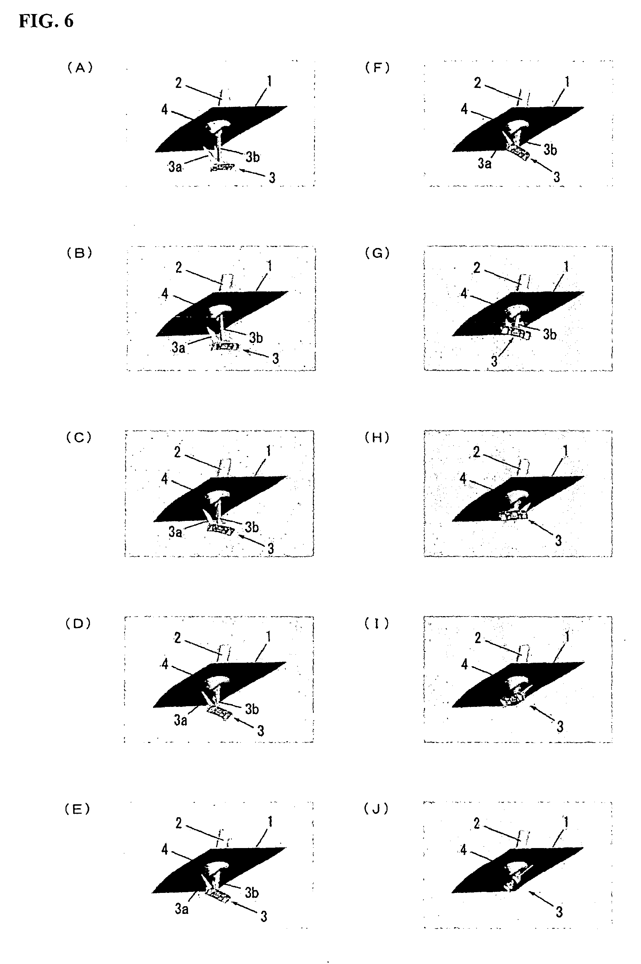

FIGS. 5 and 6 are captured images of the results of the mechanical analysis displayed in animation. FIG. 5 is a view showing the relationship between the anchor and the bell mouth when the anchor is being housed, wherein (A) to (J) show the chronological order. The bell mouth 4 is connected to the outer end of the hawse pipe 2, as shown in FIG. 5(A). The bell mouth 4 shown in the diagram is not provided with a mounting base. The anchor 3 has flukes 3a and a shank 3b, as shown in FIG. 5(A). In FIG. 5, the distal end of the shank 3b is shown from the state of entering into the bell mouth 4 to just prior to the anchor 3 being completely stored. When the chain passing through the interior of the hawse pipe 2 is pulled inward, the shank 3b of the anchor 3 arrives at the bell mouth 4, as shown in FIG. 5(A). The shank 3b is pulled into the interior of the hawse pipe 2 while making contact with the inner side of the hollow portion of the bell mouth 4, as shown in FIGS. 5(B) to 5(H). At this point, the anchor 3 is rotated so that flukes 3a are ultimately oriented downward due to the conditions, such as their weight, the reaction force from the bell mouth 4 acting on the shank 3b, the tension of the chain, the shape of the shank 3b, the orientation of the anchor 3 at the start of winding up the chain. Next, the flukes 3a contact the bell mouth 4, as shown in FIG. 5(I). In this state, the shank 3b is further pulled into the hawse pipe 2 and the surface on the opposite side of the flukes 3a of the anchor ultimately contact the bell mouth 4, as shown in FIG. 5(J).

FIG. 6 is a view showing the relationship between the anchor and the shell plating when the anchor is being housed, wherein (A) to (J) show the chronological order. The anchor 3 is housed under the same conditions as FIG. 5. An analysis is performed to determine whether the anchor 3 contacts the shell plating 1 in the process.

In the determination step (Step 5), the results of the mechanical analysis of the three-dimensional model are checked whether they satisfy predetermined conditions. The predetermined conditions can be set depending on, for example, whether a mounting base is provided at the base of the bell mouth 4.
1. The case in which a mounting base is not provided (the case in which the anchor 3 is dropped directly into the shell plating 1)
   (a) the direction of the anchor 3 in a stored state is constant;
   (b) the anchor 3 does not contact the shell plating 1 when the anchor 3 is being housed;
   (c) the anchor 3 contacts at five points (three-point contact with the bell mouth and two-point contact with the shell plating) when the anchor 3 is in a stored state; and
   (d) conditions (a) to (c) are satisfied even when the direction of rotation has changed due to the direction in which the flukes 3a of the anchor 3 have fallen down when the anchor 3 is being housed.
2. The case in which a mounting base is provided (the case in which the anchor 3 does not contact the shell plating 1 when the anchor is being stored)
   (a) the direction of the anchor 3 in a stored state is constant;
   (b) the anchor 3 and the mounting base do not contact the shell plating 1 when the anchor 3 is being housed;
   (c) the anchor 3 contacts the bell mouth at three points when the anchor is in a stored state; and
   (d) conditions (a) to (c) are satisfied even when the direction of rotation has changed due to the direction in which the flukes 3a of the anchor 3 have fallen down when the anchor 3 is being housed.
If the results of the mechanical analysis satisfy these conditions (Y), the design of the bell mouth 4 is completed (End). If the results of the mechanical analysis do not satisfy these conditions (N), the process proceeds to the shape modification step (Step 6). These determinations may be configured to be automatically made from the results of the mechanical analysis by the computer, or may be visually made from the analysis results shown in FIGS. 5 and 6.

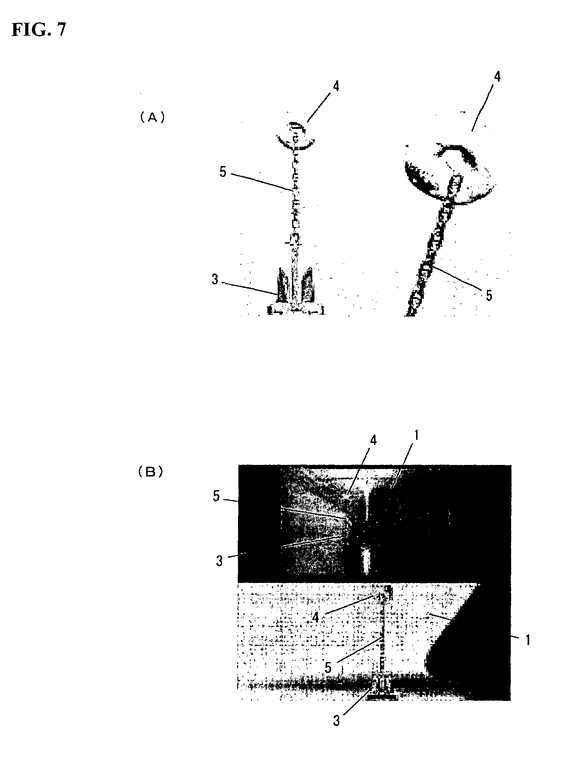

In the determination step (Step 5), conditions of the chain connected to the anchor 3 other than the behavior of the anchor 3 can be added. Examples of such chain conditions include whether the movement of the chain is smooth; whether the chain passes along a centerline; whether the chain rubs against the inner surface of the hawse pipe 2 or the deck; and whether a bending moment is generated in the chain. FIG. 7 is a view showing the relationship between the chain and the bell mouth when the anchor is being housed, wherein (A) is a front view and an enlarged view of the bell mouth, and (B) is a front view and side view of the ship. The views shown in FIGS. 7(A) and 7(B) are both views showing the analysis results of the mechanical analysis step (Step 4). FIG. 7(A) is mainly for checking the relationship between the chain 5 and the bell mouth 4, and FIG. 7(B) is mainly for checking the relationship between the chain 5 and the shell plating 1.

In the shape modification step (Step 6), the shape of the three-dimensional model of the bell mouth 4 is modified when the conditions of the determination step (Step 5) are not satisfied. Examples of the modifications in the shape modification step (Step 6) include modification of the height H of the bell mouth 4 to adjust the contact points between the anchor 3 and the bell mouth 4; modification of the difference between a lowest point and a highest point of the height H of the bell mouth 4 to adjust the swing width of the anchor 3 and the distance between the anchor and the shell plating 1; modification of the height H of the bell mouth 4 so that the anchor 3 (flukes 3a) contacts the shell plating 1 during storage in the case of the bell mouth 4 without a mounting base; modification of the height H of the bell mouth 4 so that the anchor 3 (flukes 3a) does not contact the shell plating 1 during storage in the case of the bell mouth 4 without a mounting base; modification of the curved shape of the bell mouth 4 so that the rotational direction of the anchor 3 is stable; and modification of the height H and curvature shape of the bell mouth 4 so that the anchor 3 does not contact the shell plating 1 when the anchor 3 is being housed. These shape modifications of the three-dimensional model may be made by data input from a keyboard or by mouse operation on a computer, and it is also possible to use a haptic device, in the same manner as the preliminary shape modification step (Step 3).

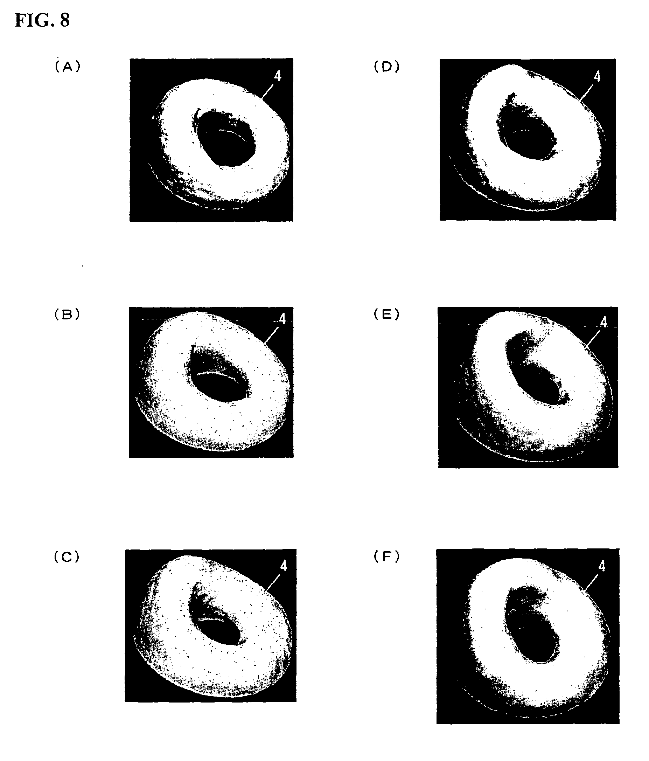

Mechanical analysis is again carried out when the shape modifications of the bell mouth 4 have ended. The mechanical analysis step (Step 4) through the shape modification step (Step 6) are repeated until the predetermined conditions are satisfied in the determination step (Step 5). FIG. 8 is a view showing a three-dimensional model in which the shape of the bell mouth has been modified, wherein (A) is a bell mouth which has undergone preliminary shape modification, and (B) to (F) show the results of repeating 1 to 5 times the mechanical analysis step (Step 4) through the shape modification step (Step 6). In FIG. 8(B), the shape of the bell mouth 4 is modified so as to have a smoother, more well-defined surface. In FIGS. 8(C) to (E), slight adjustments are made to the height of the bell mouth 4 and other factors. A shape such as that shown in FIG. 8(F) is ultimately determined.

According to the method for designing the bell mouth 4 described above, the shape of the bell mouth 4 suitable for a ship type can be designed easily on a computer without depending on specific craftsmen. Therefore, since a reduced-scale model or a wood model is no longer necessary, design time can be shortened and design costs can be reduced. A three-dimensional model of a bell mouth 4 can furthermore be accumulated as electronic data to be used in the design of a future bell mouth 4, enabling the design of a bell mouth 4 to be implemented more rapidly and at lower cost.

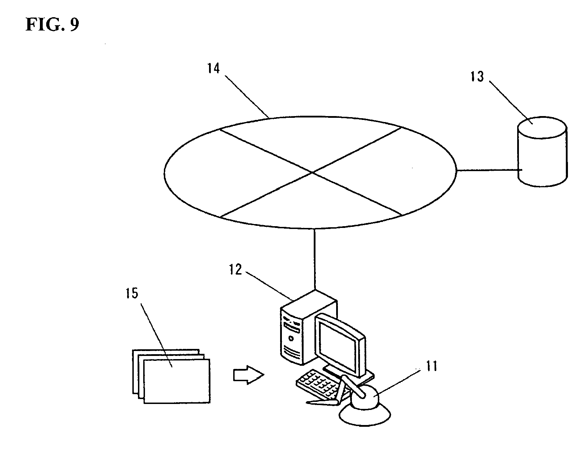

FIG. 9 is a system configuration diagram for processing the bell mouth design method according to the present invention. The system shown in FIG. 9 is an example of the implementation of the bell mouth design method described above, but no limitation is imposed by the configuration shown in the diagram. The present system has a computer 12 connected to a haptic device 11, as shown in FIG. 9. The computer 12 has a CPU (central processing unit), a RAM, a ROM, a hard disk or other storage device, a keyboard or other input device, and a display or another output device; has software for carrying out the mechanical analysis, and software or the like for processing the three-dimensional model using the haptic device 11 are stored and saved in the storage device; and is configured so that a predetermined program is executed by the CPU to carry out predetermined mechanical analysis and modify the shape of the three-dimensional model by input from the haptic device 11. The computer 12 is connected to a telecommunication circuit 14 to which other computers, servers 13, and the like are connected. The telecommunication circuit 14 is a distributed IP network built by connecting various communication lines (telephone lines, ISDN lines, ADSL lines, and other public lines; and dedicated lines, and wireless communication networks) to each other using TCP/IP communication protocol, and the IP network includes the Internet (company networks) by way of 10BASE-T, 100BASE-TX, and the like, and home networks and other LAN.

In the initial shape setting step (Step 1), the initial shape of the bell mouth 4 is selected based on the ship type and the shape of the hawse pipe 2 and anchor 3. These data may be electronic data stored in a server 13, or may be data described in diagrams 15. Next, in the three-dimensional model creation step (Step 2), a three-dimensional model of the shell plating 1, hawse pipe 2, anchor 3, and bell mouth 4 is created on the computer 12. In the preliminary shape modification step (Step 3), the initial shape of the bell mouth 4 is modified using a keyboard, haptic device 11, or another input device. In the mechanical analysis step (Step 4), a mechanical analysis of the three-dimensional model is performed using mechanical analysis software stored in the computer 12. In the shape modification step (Step 6), the shape of the bell mouth 4 is modified based on the analysis results using a keyboard, haptic device 11, or another input device.

When the shape of the bell mouth 4 has been ultimately determined, electronic data (e.g., CAD data) representing the shape of the bell mouth 4 is saved in the computer 12 or server 13. At this point, the shape data of the bell mouth 4 is preferably associated with the ship type and the shape of the hawse pipe 2 and anchor 3, and then stored and organized into a database. In this manner, the shape data of the bell mouth 4 is accumulated, whereby bell mouth shapes of existing ships are converted into CAD data and stored with their associated ship-type information in a database. The database can be used for setting a profile of the initial shape of the bell mouth 4. Therefore, a more enhanced database of the bell mouth 4 allows the initial shape of the bell mouth 4 to be more closely approximated to the final design shape, the load on the mechanical analysis step (Step 4) and the shape modification step (Step 6) to be reduced, and the shape of the bell mouth 4 to be determined easily and rapidly. The three-dimensional model creation step (Step 2) through the shape modification step (Step 6) can be omitted and the shape of the bell mouth 4 can be determined for a ship having the same conditions.

### Working example

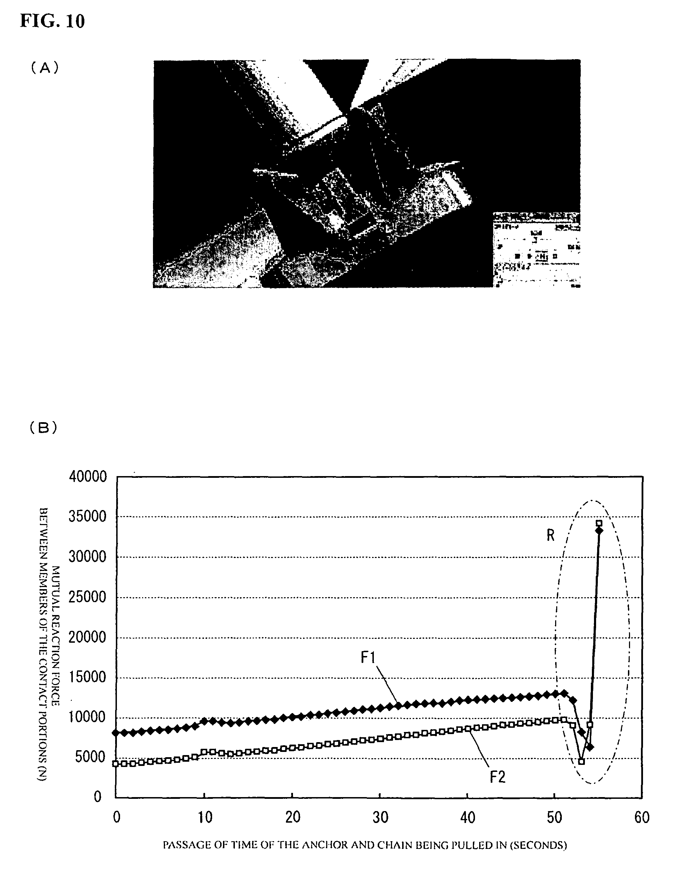

A working example of the present invention is described below. FIG. 10 is a view showing an example of the bell mouth design method of the present invention, wherein (A) is the state after the anchor has been housed as seen from the ship stern side and (B) is an example of the computational results of the reaction force during contact.

### (1) Outline of mechanical analysis

Mechanical analysis is a CAE (computer-aided engineering) tool for computing movement in a time domain in a machine system composed of a plurality of components. Such a tool ordinarily treats all components as rigid bodies without consideration for deformation, defines the mechanics and forces between the components constituting an assembly, synchronizes a model depending on degrees of freedom of the components, and computes reaction forces and other dynamics in operation between the components. In other words, mechanical analysis refers to motion simulation, interference checking, and computation of dynamics. "NX Motion Simulation-RecurDyn" is included in the mechanical analysis software "NX Design" used in the working example, and it is possible to perform kinematics and dynamics motion analysis related to a rigid multibody system and static equilibrium. "Recur" refers "Recursive method," which is a method for expressing a motion equation using relative coordinates between mutually linked and adjacent objects, and reducing the number of coordinates to increase computing efficiency. For example, a mechanical analysis related to the housing of an anchor and chain requires three definitions: link definition, joint definition, and three-dimensional contact definition. Specifically, (1) link definition: to define individually each link in the model used in the mechanical analysis; (2) joint definition: to define non-movement, and rotation, sliding, and other movements; and (3) three-dimensional contact definition: to specify and define models for which contact computation is desired. Mechanical analysis is carried out when these definitions have been completed.

### (2) Results of mechanical analysis

Sliding in the joints during anchor and chain lifting will be defined. A model of the distal end of the chain is selected, the direction of the sliding is determined, and the sliding speed is inputted for the target joint. The time is furthermore inputted to determine the movement distance. When the distal end of the chain moves, the trailing anchor and chain contact thereby being pulled because a three-dimensional contact is defined for the anchor and chain. Actual pulling has two patterns, i.e., a pattern for when the flukes of the anchor are facing the ship hull and a pattern for when the flukes are facing outward. When the chain is pulled in the outward facing state, the anchor flukes initially contact the ship bow side of the bell mouth and are ultimately secured facing the ship stern side. During the interval, the anchor rubs against the upper portion and ship bow side of the bell mouth and rotates. When the chain is pulled in the ship hull-facing state, the anchor rubs against the lower portion to the ship stern side of the bell mouth, and is secured in the same position while rotating in the opposite direction. A mechanical analysis is carried out for these two patterns. As a result of checking the operation in a three-dimensional CAD, it was possible to reproduce substantially the same operation as the model test using a reduced-scale model. FIG. 10(A) is a view showing a portion of the mechanical analysis results and shows the state after the anchor has been housed as seen from the ship stern side.

### (3) Determination of the final shape

When the condition of the anchor being housed has been successfully reproduced as a result of the mechanical analysis, the shape of the bell mouth with which the condition of the anchor being housed has been successfully reproduced is its final shape as long as the condition of the anchor in a midway anchor-lift state and the condition of the anchor being housed are satisfactory, as shown in FIG. 10(A). However, when excessive force acts on the ship hull or other defects occur in the stored state and midway anchor-lift state, the three-dimensional model of the bell mouth must be modified and the mechanical analysis performed again. FIG. 10(B) shows an example of the result of computing reaction forces during contact. In FIG. 10(B), the vertical axis represents the reaction force (N) between members at the contact portions, and the horizontal axis represents the passage of time (seconds) of the anchor and chain being pulled in. F1 (black diamond) shows the reaction force of the joint that connects the shank and the anchor main body, and F2 (white square) shows the reaction force of the joint that connects the anchor flukes and the anchor main body. A considerable change appeared from the area (the R portion in the diagram) in which the anchor contacted the bell mouth, as shown in FIG. 10. This change shows the reaction force generated between the flukes and the anchor main body when the fluke portion engages the bell mouth as the anchor main body is being housed. In this manner, modification of the three-dimensional model of the bell mouth and mechanical analysis are repeated until the reaction forces are no longer generated or until the reaction forces reach a level that does not cause a problem, when that excessive reaction forces act midway through the housing of the anchor. For example, modification and mechanical analysis of the three-dimensional model of the bell mouth are not required to be repeated as long as change is on the level of the protruding portions of F1 an F2 at about 10 seconds of elapsed time for pulling in the anchor and chain.

The present invention is not limited to the embodiments described above; the various modifications will become apparent without departing from the scope and spirit of the present invention.

### BRIEF DESCRIPTION OF DRAWINGS

FIG. 1 is a process flowchart showing the bell mouth design method according to the present invention;
FIG. 2 is a diagram showing the initial shape of a bell mouth, wherein (A) is the external appearance of the initial shape and (B) is the external appearance of a bell mouth which has undergone preliminary shape modification;
FIG. 3 is a view showing the preliminary shape modification step using a three-dimensional model, wherein (A) shows the anchor storage state and (B) shows the bell mouth which has undergone preliminary shape modification;
FIG. 4 is a view showing the state of mechanical analysis, wherein (A) is a bird's-eye view, (B) is a side view from the rear of the anchor, (C) is a side view from the front of the anchor, and (D) is a plan view;
FIG. 5 is a view showing the relationship between the anchor and the bell mouth when the anchor is being housed, wherein (A) to (J) show the chronological order;
FIG. 6 is a view showing the relationship between the anchor and the shell plating when the anchor is being housed, wherein (A) to (J) show the chronological order;
FIG. 7 is a view showing the relationship between the chain and the bell mouth when the anchor is being housed, wherein (A) is a front view and an enlarged view of the bell mouth, and (B) is a front view and side view of the ship;
FIG. 8 is a view showing a three-dimensional model in which the shape of the bell mouth has been modified, wherein (A) is a bell mouth which has undergone preliminary shape modification, and (B) to (F) show the results of repeating 1 to 5 times the mechanical analysis step (Step 4) through the shape modification step (Step 6);
FIG. 9 is a system configuration diagram for processing the bell mouth design method according to the present invention; and
FIG. 10 is a view showing an example of the bell mouth design method of the present invention, wherein (A) is the state after the anchor has been housed as seen from the ship stern side and (B) is an example of the computational results of the reaction force during contact.

## Claims

1. A method for designing a bell mouth in a ship having a hawse pipe formed in a shell plating of the ship, an anchor arranged so as to be raised and lowered by a chain passing through the hawse pipe, and a bell mouth arranged on an outer end of the hawse pipe, the method for designing a bell mouth comprising:
an initial shape setting step for setting an initial shape of the bell mouth depending on a type of ship, and a shape of the hawse pipe and the anchor;
a three-dimensional model creation step for creating a three-dimensional model of the bell mouth, the hawse pipe, and the anchor on a computer;
a mechanical analysis step for performing a mechanical analysis of the condition of the anchor being housed using the three-dimensional model of the bell mouth, the hawse pipe, and the anchor on the computer;
a determination step for checking whether results of the mechanical analysis satisfy predetermined conditions; and
a shape modification step for modifying the three-dimensional model of the bell mouth on the computer on the basis of the results of the mechanical analysis,
wherein a shape of the bell mouth is decided while repeating the mechanical analysis step and the shape modification step.

2. The bell mouth design method according to claim 1, **characterized in** comprising a preliminary shape modification step for modifying an outer peripheral shape of the three-dimensional model of the bell mouth so as to be rotatable when the anchor contacts the initial shape of the bell mouth, after the three-dimensional creation step.

3. The bell mouth design method according to claim 1, **characterized in that** an internal diameter of the initial shape of the bell mouth is set based on a diameter of the hawse pipe in the initial shape setting step.

4. The bell mouth design method according to claim 1, **characterized in that** an external diameter and a height of the initial shape of the bell mouth is set based on a size of and the shape of the anchor in the initial shape setting step.

5. The bell mouth design method according to claim 1, **characterized in that** a profile of the initial shape of the bell mouth is set in the initial shape setting step using a database in which bell mouth shapes of existing ships have been converted into CAD data and stored with their associated ship-type information.

6. The bell mouth design method according to claim 1, **characterized in that** a mechanical analysis is performed for the condition of the anchor in a stored or anchored state in addition to the condition of the anchor being housed in the mechanical analysis step.

7. The bell mouth design method according to claim 1 or 2, **characterized in that** the three-dimensional model of the bell mouth is modified on the computer in the shape modification step or the preliminary shape modification step using a haptic device.

8. The bell mouth design method according to claim 1, **characterized in that** the predetermined conditions in the determination step are that a direction of the anchor in a stored state is constant; that the anchor does not contact the shell plating when the anchor is being housed; and that the anchor contacts the bell mouth at three points when the anchor is in a stored state.

9. The bell mouth design method according to claim 1, **characterized in that** a height of the bell mouth to adjust contact points between the anchor and the bell mouth in the shape modification step.

10. The bell mouth design method according to claim 1, **characterized in that** a difference between a lowest point and a highest point of a height of the bell mouth is modified to adjust a swing width of the anchor and a distance between the anchor and the shell plating in the shape modification step.
